# EUROPÄISCHE PATENTSCHRIFT

(11) **EP 2 532 129 B1**
(45) Veröffentlichungstag und Bekanntmachung des Hinweises auf die Patenterteilung: **18.06.2014**
(21) Anmeldenummer: 10710772.4
(22) Anmeldetag: 05.02.2010
(51) Int. Cl.: H04L 25/02, H03K 5/24, H03K 19/0175

(54) **EMPFÄNGER IN EINEM BUSKNOTEN EINES BUSNETZES**
RECEIVER IN A BUS NODE OF A BUS NETWORK
RÉCEPTEUR DANS UN NOEUD DE BUS D'UN RÉSEAU DE BUS

(43) Veröffentlichungstag der Anmeldung: 12.12.2012
(73) Patentinhaber: Gira Giersiepen GmbH & Co. Kg, 42477 Radevormwald (DE); Tapko Technologies GmbH, 93059 Regensburg (DE)
(72) Erfinder: TOMIC, Petar, 93049 Regensburg (DE); ADLER, Klaus, 93173 Wenzenbach (DE); SEIFERT, Roland, 59071 Hamm (DE); KEMMANN, Harald, 42555 Velbert (DE); LASKIWITZ, Ingo, 42929 Wermelskirchen (DE)
(74) Vertreter: Tönhardt, Marion
(86) Internationale Anmeldenummer: PCT/DE2010/000132
(87) Internationale Veröffentlichungsnummer: WO 2011/095142

(56) Entgegenhaltungen:
- EP-A1- 0 736 975
- WO-A1-2007/003254
- US-A- 5 689 199
- US-A1- 2002 000 847
- ocXtreme.org: "Understanding GTL Reference Voltage", , 24. Dezember 2008 (2008-12-24), Seiten 1-8, XP002611244, Gefunden im Internet: URL:http://www.ocxtreme.org/index/?p=3 [gefunden am 2010-11-23]

## Beschreibung

Die vorliegende Erfindung betrifft einen Empfänger in einem Busknoten eines Busnetzes, insbesondere eines EIB-Netzes, der an eine Buslinie gekoppelt ist, welche dem Empfänger ein aus Bitpulsen gebildetes Signal zur Verfügung stellt.

Busnetze dienen dazu, kommunikationsfähige Geräte miteinander zu vernetzen. Dazu enthalten diese Geräte jeweils einen Busknoten mit einem Sender, einem Empfänger und gegebenenfalls einer Spannungsversorgung, die die interne Schaltung und möglichst auch, falls vorhanden, Applikationsschaltungen versorgt.

Busknoten, die in einem EIB-Netz eingesetzt werden sollen, müssen strenge Anforderungen erfüllen, die im Konnex Handbuch, Version 2.0, festgelegt sind. Anhand dieser Anforderungen erfolgt eine Zertifizierung der fertigen Geräte. Dabei sind zur Sicherstellung der diversen Eigenschaften bestimmte Tests vorgeschrieben.

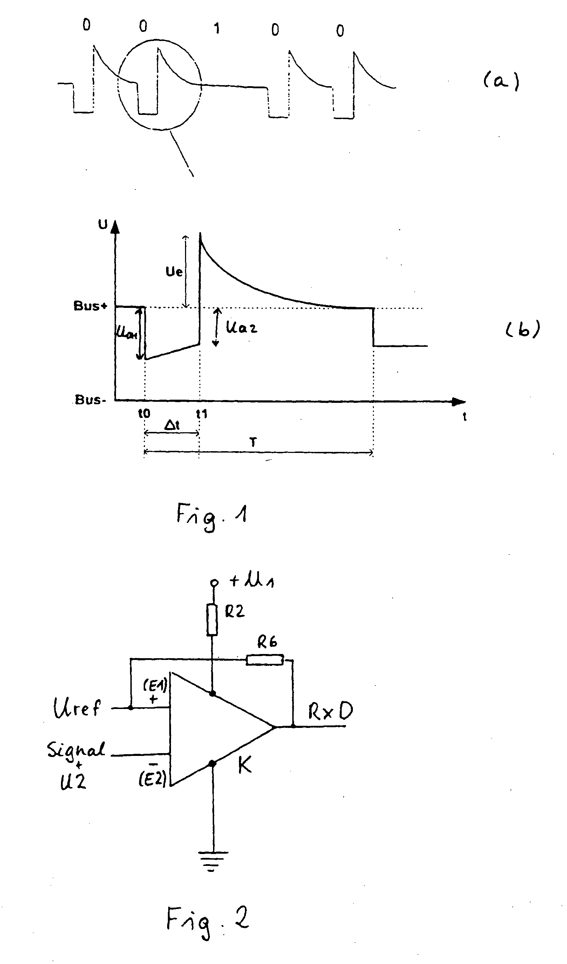

In Figur 1 ist in Teilbild (a) eine Bitfolge aus einem EIB-Beispieltelegramm dargestellt, das entsprechend einer Folge von Impulsen eines Sendesignals generiert wird, in Teilbild (b) sind die Einzelheiten eines einzelnen Bitimpulses gezeigt. Bus+ ist die nominale Busspannung, Bus- stellt für die weitere Betrachtung das gemeinsame Potential, d. h. das Massepotential, dar. Das EIB-Signal eines einzelnen Sendeimpulses ist durch einen zeitlich begrenzten und in der Dauer Δt mit dem Sendeimpuls synchronisierten, durch Ua1 und Ua2 gekennzeichneten Spannungseinbruch, im Allgemeinen als Aktivimpuls bezeichnet, ab der nominalen Busspannung Bus+ definiert. Zum Zwecke der Energieminimierung beim Senden einer Nachricht erfolgt anschließend eine definierte Spannungsüberhöhung Ue über die nominale Busspannung Bus+ hinaus, die den sogenannten Ausgleichsimpuls einleitet. Im Zusammenspiel mit einem Drosselmodul als Impedanzwandler der Busnetzteile, das dabei gleichzeitig einen Energiespeicher darstellt, erfolgt nach jedem aktiven Signal (Sendeimpuls) eine Energierückführung auf die Busleitung. Danach klingt der Ausgleichsimpuls als exponentielle Funktion ab, bis nach Ablauf der Bitperiode T das nächste Bit eines Telegramms erscheint. Dann muss der Ausgleichsimpuls vollständig abgeklungen sein, damit für das nächste Bit definierte Spannungsbedingungen sichergestellt sind. Das Konnex Handbuch, Version 2.0, definiert beispielsweise auch die Toleranzgrenzen, die die Spannungswerte unter den verschiedensten Bedingungen einhalten müssen.

Abhängig von der Buskonfiguration, der Länge der Leitungen, der Anzahl der am Bus angeschlossenen Geräte und der effektiven Höhe der Bus-Gleichspannung wird das Spannungssignal eines Senders bedämpft und kommt unter Umständen nur mit sehr geringer Amplitude beim Empfänger an. Das Nutzsignal muss jedoch noch deutlichen Störabstand zu eingekoppelten Störungen sowie Rauschen auf der Busleitung haben. Außerdem müssen überlagerte Hochfrequenzanteile der Einkopplung aus dem Signal herausgefiltert werden.

Andererseits darf der Empfänger jedoch nicht übersteuert werden, da Übersteuerungen zu einer derartigen Verformung des Signals führen können, dass es nicht mehr als Nutzsignal erkannt wird. Hohe Signalpegel treten beispielsweise auf, wenn auf der Buslinie zwei Geräte nahe beieinander liegen, wobei eines sendet und das andere empfängt, bei einer geringen Anzahl von Geräten auf der Buslinie und zusätzlich hoher Bus-Gleichspannung. Um Übersteuerungen zu verhindern, dürfen die Signale daher einen oberen Schwellenwert für die Funktionstoleranzgrenzen nicht überschreiten.

Der dynamische Spannungsbereich eines Empfängers ist somit ebenfalls definiert. Dabei gelten für Empfänger in einem EIB-Netz die Werte aus der nachstehenden Tabelle 1. Es sind die Spannungswerte angegeben, bei denen ein Empfänger das Spannungssignal zur Auswertung durch die Steuereinheit weitergibt oder sperren muss, womit ein unterer Schwellenwert für die Funktionstoleranzgrenzen festgelegt ist.

**Tabelle 1**

| **Testschritt** | **Ua₁(V)** | **Ua₂(V)** | **Empfang?** |
|---|---|---|---|
| 1 | 9 | 9 | Ja |
| 2 | 0,7 | 0.5 | Ja |
| 3 | 0,2 | 0,2 | Nein |

Im Konnex Handbuch, Version 2.0, Volume 8: KNX System Conformance Testing, Part 2: Medium Dependant Layers Test, Chapter 2: TP1 Physical and Link Layer,. Test 5.2-Sensitivity, wird eine Messmethode beschrieben, mit der die erforderlichen Eigenschaften des Empfängers geprüft werden können. Dabei müssen die Spannungswerte aus der Tabelle 1 erreicht werden, damit eine Zertifizierung für den getesteten EIB-Empfänger möglich ist.

Ein Empfänger mit einem Differenzverstärker, welcher einen ersten Eingang und einen zweiten Eingang und mindestens einen Ausgang aufweist, wobei an dem ersten Eingang eine Referenzspannung anliegt und an dem zweiten Eingang eine das Signal tragende Spannung anliegt, die so ausgelegt ist, dass nur dann ein Signal am Ausgang erscheint, wenn der Absolutwert der Spannung am zweiten Eingang größer ist als der Absolutwert der Referenzspannung am ersten Eingang, ist aus der US 5,689,199 bekannt. Der dort beschriebene, in BipolarTechnologie aufgebaute Differenzverstärker wirkt als Komparator mit einer Hysterese, die dadurch erzeugt werden kann, dass ein Spannungssignal proportional zu dem Ausgangssignal einer Stromquelle zu einem Spannungseingang des Differenzverstärkers zurückgespeist wird, vorzugsweise zu dem Eingang des Differenzverstärkers, an dem das Referenzpotential liegt. Der Differenzverstärker kann vorzugsweise als Stromspiegelschaltung gestaltet sein.

Für solche Rückkopplungsschaltungen ist es bekannt, beispielsweise aus der EP 0 736 975 A1, große Widerstandswerte zu verwenden, um zu vermeiden, dass die Schaltung eine unerwünscht geringe Verstärkung hat. Die in der EP 0 736 975 A1 als Stand der Technik beschriebene Schaltung benutzt einen Rückkopplungswiderstand von 1 Mega-Ohm.

Es ist die Aufgabe der Erfindung, den eingangs beschriebenen Empfänger so zu gestalten, dass er hinsichtlich Empfindlichkeit, Dynamik und Störsicherheit optimiert ist. Auch soll er übersteuerungsfest ausgelegt sein, wobei zugleich eine Anpassung des Ausgangspegels an die zulässige Eingangsspannung einer angeschlossenen Steuereinheit, beispielsweise eines Mikroprozessors, möglich sein soll.

Diese Aufgabe wird durch einen Empfänger nach Anspruch 1 gelöst. Vorteilhafte Ausgestaltungen sind Gegenstand der Unteransprüche. Eine Verwendung ist im Anspruch 5 angegeben.

Erfindungsgemäß ist eine Spannungsquelle vorgesehen, welche einerseits die das Signal tragende Spannung zur Verfügung stellt und aus welcher andererseits die Referenzspannung abgeleitet ist. So wird sichergestellt, dass die das Signal tragende Spannung immer in einer bestimmten Relation zur Referenzspannung steht, wobei die letztere in Abhängigkeit von der Singaltiefe (Ua1, Ua2, s. Figur 1) zu wählen ist.

Auch ist bei dieser Schaltung zum Sicherstellen der Stabilität im Verhalten der Empfängerschaltung ein Rückkopplungswiderstand vorgesehen, der den Ausgang mit dem ersten Eingang koppelt. Damit werden der Schaltung die vorteilhaften Eigenschaften eines Schmitt-Triggers verliehen.

Die Erfindung verleiht einem Differenzverstärker somit eine Komparatorfunktion, welche die Abhängigkeit beispielsweise von der Basis-Emitter-Spannung eines Transistors eliminiert, die im Stand der Technik verwendet wird, um den unteren Schwellenwert für die Funktionstoleranzgrenzen einzuhalten.

Vorzugsweise besteht der Differenzverstärker mindestens aus einem ersten Transistor und einem zweiten Transistor in Emitterschaltung mit gemeinsamen Emitterwiderstand, wobei die Basis des ersten Transistors den zweiten Eingang und die Basis des zweiten Transistors den ersten Eingang des Differenzverstärkers bildet. Bei dieser Ausgestaltung wäre dann der erste Eingang als positiver Komparatoreingang anzusehen, an dem die Referenzspannung liegt. Der zweite Eingang wäre als negativer Komparatoreingang anzusehen, an dem das ankommende Signal anliegt. Die Referenzspannung legt somit den unteren Schwellenwert für die Funktionstoleranzgrenzen gemäß Tabelle 1 fest.

Weiter vorteilhaft ist vorgesehen, dass der Kollektor des ersten Transistors den Ausgang bildet.

Nach einer bevorzugten Ausgestaltung der Erfindung weist der Differenzverstärker einen Stromspiegel auf, dessen Eingang mit dem Kollektor des zweiten Transistors verbunden ist und dessen Ausgang mit dem Kollektor des ersten Transistors verbunden ist. Mit dieser Maßnahme wird einer Übersteuerung entgegengewirkt, da hier ein Schwellenwert für die obere Funktionstoleranzgrenze definiert wird, die aus schaltungstechnischen Gründen nicht überschritten werden kann.

Schließlich beschreibt die Erfindung die Verwendung eines Empfängers nach einem der Ansprüche 1 bis 4 in einer anwendungsspezifischen integrierten Schaltung (ASIC - *Application Specific Integrated Circuit*), die dann auch weitere Schaltungsteile umfassen könnte, beispielsweise einen Sender, eine Spannungsversorgung, ein Spannungsnetzteil und dergleichen.

Im Folgenden soll die Erfindung anhand der beigefügten Zeichnung näher erläutert werden.
- Figur 1: zeigt im Teilbild (a) eine Bitfolge aus einem EIB-Beispieldiagramm und im Teilbild (b) die Einzelheiten eines Bitimpulses aus der Bitfolge.
- Figur 2: zeigt ein Ersatzschaltbild eines Empfängers gemäß einem Ausführungsbeispiel der vorliegenden Erfindung.
- Figur 3: zeigt ein Ausführungsbeispiel eines Empfängers gemäß der vorliegenden Erfindung in einem diskreten Aufbau.

In der nachfolgenden Beschreibung und in den Zeichnungen sind zahlreiche bestimmte Einzelheiten aufgeführt. Es wird jedoch verstanden, dass Ausführungsformen der vorliegenden Erfindung ohne diese bestimmten Einzelheiten in die Praxis umgesetzt werden können. In anderen Fällen sind gut bekannte Schaltungen, Strukturen und Techniken wegzulassen, um das Verständnis der Erfindung nicht zu erschweren. Es wird verstanden, dass an den dargestellten Ausführungsformen zahlreiche Modifikationen und Abänderungen vorgenommen werden können, ohne dass man sich vom Umfang der Erfindung entfernt. Das dargestellte Ausführungsbeispiel sollten daher als beschreibend und nicht als beschränkend angesehen werden. Insbesondere ist denkbar, dass, obwohl das Ausführungsbeispiel mit bipolaren Transistoren aufgebaut sind, andere Technologien eingesetzt werden können, so dass die Schaltung z. B. mit Feldeffekttransistoren realisiert werden könnte.

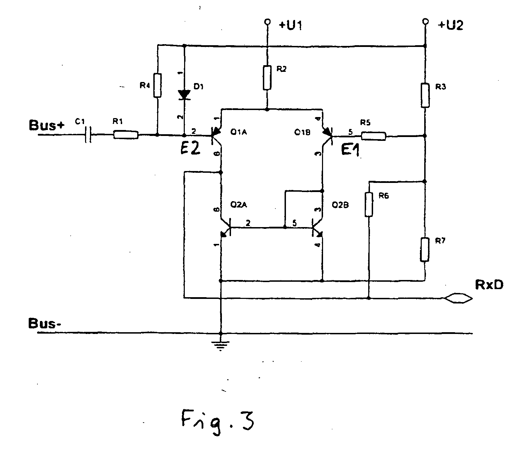

Figur 2 zeigt ein Ersatzschaltbild für einen Empfänger gemäß der vorliegenden Erfindung, mit dem die Komparatorfunktionalität erläutert werden soll. Ein Komparator K wird von einer Spannung U1 versorgt, die höher angesetzt ist, als alle weiteren in der Schaltung vorliegenden Spannungen. Am positiven Eingang des Komparators K, der einem ersten Eingang E1 eines Differenzverstärkers entspricht, liegt eine Referenzspannung Uref, die einen unteren Schwellenwert für die Funktionstoleranzgrenzen bildet. Diese Referenzspannung Uref wird, wie noch im Zusammenhang mit Figur 3 beschrieben wird, aus einer vorzugsweise stabilisierten Versorgungsspannung U2 abgeleitet. Diese Spannung U2 trägt auch das Signal, das aus der Buslinie, insbesondere aus Bus+, herausgefiltert worden ist, und wird mit dem Signal an den negativen Eingang des Komparators K gelegt, der dem zweiten Eingang E2 des Differenzverstärkers entspricht. Der Komparator K vergleicht die Spannungen an seinem positiven und negativen Eingang und gibt entsprechend auf seinem Ausgang RxD ein Ausgangssignal aus. Ein Rückkopplungswiderstand R6, der den Ausgang RxD des Komparators K mit seinem positiven Eingang verbindet, stabilisiert das Verhalten des Komparators.

Figur 3 zeigt eine Ausführungsform eines Empfängers gemäß der vorliegenden Erfindung in einem diskreten Aufbau. Dabei bilden die im Wesentlichen identischen Transistoren Q1A und Q1B, die mit einem gemeinsamen Emitterwiderstand R2 in Emitterschaltung angeordnet sind, den eigentlichen Differenzverstärker, der durch einen Stromspiegel, gebildet aus den Transistoren Q2A und Q2B ergänzt ist. U1 ist eine erste Versorgungsspannung, die den Differenzverstärker mit Komparatorfunktion versorgt, wobei der Widerstand R2 zum Einstellen des Emitterstroms dient. U2 ist eine zweite Versorgungsspannung, die stabilisiert ist und zur genauen Einstellung der geforderten Schwellenwerte für die Funktionstoleranzgrenzen dient. Durch Vorgabe der Spannung U2 an der Basis des Transistors Q1A bzw. des Transistors Q1B wird die Emitterspannung, die ja auch die Versorgungsspannung des Komparators ist, auf deren Wert, zusätzlich der Spannung einer Basis-Emitter-Strecke eingeregelt. Die Basis des Transistors Q1A bildet einen zweiten Eingang E2 des Differenzverstärkers, die Basis des Transistors Q1B einen ersten Eingang E1 des Differenzverstärkers.

Am Ausgang RxD wird das verarbeitete Nutzsignal an die Steuereinheit, z. B. einen Mikroprozessor, weitergegeben. Da die Versorgungsspannung, wie oben beschrieben, heruntergezogen ist, ist auch das Signal auf RxD an die zulässige Eingangsspannung der Steuereinheit angepasst.

An den zweiten Eingang E2 wird die Spannung U2 über den Widerstand R4 direkt angelegt. An diesem zweiten Eingang E2 liegt auch das Bussignal, das mittels des Kondensators C1, der für eine Gleichspannungsentkopplung sorgt, aus der Busspannung Bus+ herausgezogen worden ist. Die Spannung U2 dient damit als eine das Signal tragende Spannung. Eine Diode D1 ist zum Schutz des zweiten Eingangs E2 gegen Überspannungen vorgesehen. Zusätzlich bildet der Widerstand R1 mit den Eingangskapazitäten des Transistors Q1A und der Diode D1 einen Filter gegen hochfrequente Anteile im ankommenden Signal.

Der erste Eingang E1 ist über den Widerstand R5 an einen Spannungsteiler, bestehend aus den Widerständen R3 und R7, angeschlossen, an dem die Referenzspannung Uref abgegriffen wird. Der Spannungsteiler R3, R7 ist so dimensioniert, dass diese Spannung etwas unterhalb der Spannung U2 liegt.

Ein Widerstand R6 ist als Rückkopplungswiderstand zwischen den Ausgang RxD und den ersten Eingang E1 geschaltet. Hiermit wird eine leichte Hysterese eingestellt, die für die Stabilität im Verhalten des Empfängers sorgt.

Durch die Funktionalität des Differenzverstärkers ist der Transistor Q1A im Ruhezustand gesperrt, der Transistor Q2A ist durchgeschaltet. Der Ausgang RxD ist low.

Wenn nun ein Bitsignal einen Pegel innerhalb der beiden Schwellenwerte für die Funktionstoleranzgrenzen gemäß Tabelle 1 hat, wird das Signal vom Eingang Bus+ über den Kondensator C1 und den Widerstand R1 an den Eingang E2 übertragen. Da das Signal eine negative Polarität hat, wird die Spannung U2 heruntergezogen und überschreitet als Absolutwert die Referenzspannung Uref am Eingang E1. Der Transistor Q1A wird jetzt durchgeschaltet, der Transistor Q2A gesperrt. Der Ausgang RxD ist für die Zeitdauer des Bitsignals high.

Ein Bussignal mit einem Pegel unterhalb des unteren Schwellenwerts für die Funktionstoleranzgrenzen bewirkt keine Umschaltung im Differenzverstärker, da es im Absolutwert die Referenzspannung Uref nicht überschreitet.

Ein Bussignal oberhalb des oberen Schwellwertes für die Funktionstoleranzgrenze führt nicht zu einer Übersteuerung, da der konstante Basisstrom für den Transistor Q2A aus dem Referenzzweig Q1B und Q2B einen Anstieg des Stromes im Zweig Q1A und Q2A verhindert. Das ankommende Signal wird dadurch nicht verformt.

Bei optimaler Dimensionierung der Widerstände R1, R4, des Spannungsteilers R3, R7 und des Rückkopplungswiderstandes R6 kann das Verhalten des Empfängers hinsichtlich geforderter Empfindlichkeit, Dynamik und Störsicherheit erreicht werden.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

## Patentansprüche

1. Empfänger in einem Busknoten eines Busnetzes, insbesondere eines EIB-Netzes, der an eine Buslinie (Bus+, Bus-) gekoppelt ist, die dem Empfänger ein aus Bitpulsen gebildetes Signal zur Verfügung stellt, mit
- einem Differenzverstärker (Q1A, Q1B, Q2A, Q2B), welcher einen ersten Eingang (E1) und einen zweiten Eingang (E2) und mindestens einen Ausgang (RxD) aufweist, wobei an dem ersten Eingang (E1) eine Referenzspannung (Uref) anliegt und an dem zweiten Eingang (E2) eine das Signal tragende Spannung anliegt, die so ausgelegt ist, dass nur dann ein Signal am Ausgang (RxD) erscheint, wenn der Absolutwert der Spannung am zweiten Eingang (E2) größer ist als der Absolutwert der Referenzspannung (Uref) am ersten Eingang, **dadurch gekennzeichnet, dass** eine Spannungsquelle (+U2) vorgesehen ist, welche einerseits die das Signal tragende Spannung zur Verfügung stellt und aus welcher andererseits die Referenzspannung (Uref) abgeleitet ist, wobei zwischen den Ausgang (RxD) und den ersten Eingang (E1) des Differenzverstärkers ein Rückkopplungswiderstand (R6) geschaltet ist.

2. Empfänger nach Anspruch 1, **dadurch gekennzeichnet, dass** der Differenzverstärker (Q1A, Q1B, Q2A, Q2B) mindestens aus einem ersten Transistor (Q1A) und einem zweiten Transistor (Q1B) in Emitterschaltung mit gemeinsamem Emitterwiderstand (R2) aufgebaut ist, wobei die Basis des ersten Transistors (Q1A) den zweiten Eingang (E2) und die Basis des zweiten Transistors (Q1B) den ersten Eingang (E1) des Differenzverstärkers bildet.

3. Empfänger nach Anspruch 2, **dadurch gekennzeichnet, dass** der Kollektor des ersten Transistors (Q1A) den Ausgang (RxD) bildet.

4. Empfänger nach Anspruch 2, **dadurch gekennzeichnet, dass** der Differenzverstärker (Q1A, Q1B, Q2A, Q2B) einen Stromspiegel (Q2A, Q2B) aufweist, dessen Eingang mit dem Kollektor des zweiten Transistors (Q1B) verbunden ist und dessen Ausgang mit dem Kollektor des ersten Transistors (Q 1 A) verbunden ist.

5. Verwendung eines Empfängers nach einem der Ansprüche 1 bis 4 in einer anwendungsspezifischen elektrischen Schaltung.

## Claims

1. A receiver in a bus node of a bus network, in particular an EIB network, said bus node being coupled to a bus line (bus+, Bis-) that provides the receiver with a signal formed from bit pulses, comprising
- a differential amplifier (Q1A, Q1B, Q2A, Q2B), which has a first input (E1) and a second input (E2) and at least one output (RxD), wherein a reference voltage (Uref) is present at the first input (E1) and a voltage carrying the signal is present at the second input (E2), the voltage carrying the signal being designed in such a way that a signal appears at the output (RxD) only if the absolute value of the voltage at the second input (E2) is greater than the absolute value of the reference voltage (Uref) at the first input,
**characterized in that** a voltage source (+U2) is provided which, on the one hand, supplies the voltage carrying the signal, and from which, on the other hand, the reference voltage (Uref) is derived, wherein a resistor (R6) is coupled in the feedback loop between the output (RxD) and the first input (E1).

2. The receiver of claim 1, **characterized in that** the differential amplifier (Q1A, Q1B, Q2A, Q2B) is built up from at least a first transistor (Q1A) and a second transistor (Q1B) in an emitter circuit with common emitter resistor (R2), wherein the basis of the first transistor (Q1A) forms the second input (E2) of the differential amplifier and the basis of the second transistor (Q1B) forms the first input (E1) thereof.

3. The receiver of claim 2, **characterized in that** the collector of the first transistor (Q1A) forms the output (RxD).

4. The receiver of claim 2, **characterized in that** the differential amplifier (Q1A, Q1B, Q2A, Q2B) comprises a current minor (Q2A, Q2B), the input thereof being connected with the collector of the second transistor (Q1B) and the output thereof being connected with the collector of the first transistor (Q1A).

5. Use of a receiver according to any of claims 1 to 4 in an application specific integrated circuit.

## Revendications

1. Récepteur dans un noeud de bus d'un réseau de bus, plus particulièrement d'un réseau EIB, qui est couplé à une ligne de bus (Bus+, Bus-), qui met à la disposition du récepteur un signal constitué d'impulsions binaires, avec
- un amplificateur différentiel (Q1A, Q1B, Q2A, Q2B), qui comprend une première entrée (E1) et une deuxième entrée (E2) et au moins une sortie (RxD), une tension de référence (Uref) étant appliquée à la première entrée (E1) et une tension portant le signal étant appliquée à la deuxième entrée (E2), qui est conçue de façon à ce qu'un signal n'apparaît à la sortie (RxD) que lorsque la valeur absolue de la tension au niveau de la deuxième entrée (E2) est supérieure à la valeur absolue de la tension de référence (Uref) au niveau de la première entrée, **caractérisé en ce qu'**une source de tension (+U2) est prévue, qui d'une part met à disposition la tension portant le signal et d'autre part, à partir de laquelle la tension de référence (Uref) est dérivée, une résistance de couplage de retour (R6) étant branchée entre la sortie (RxD) et la première entrée (E1) de l'amplificateur différentiel.

2. Récepteur selon la revendication 1, **caractérisé en ce que** l'amplificateur différentiel (Q1A, Q1B, Q2A, Q2B) est constitué d'au moins un premier transistor (Q1A) et d'un deuxième transistor (Q1B) avec branchement émetteur, avec une résistance d'émetteur (R2) commune, la base du premier transistor (Q1A) constituant la deuxième entrée (E2) et la base du deuxième transistor (Q1B) constituant la première entrée (E1) de l'amplificateur différentiel.

3. Récepteur selon la revendication 2, **caractérisé en ce que** le collecteur du premier transistor (Q1A) constitue la sortie (RxD).

4. Récepteur selon la revendication 2, **caractérisé en ce que** l'amplificateur différentiel (Q1A, Q1B, Q2A, Q2B) comprend un miroir de courant (Q2A, Q2B) dont l'entrée est relié au collecteur du deuxième transistor (Q1B) et dont la sortie est reliée au collecteur du premier transistor (Q1A).

5. Utilisation d'un récepteur selon l'une des revendications 1 à 4, dans un circuit électrique spécifique à l'application.
